Europäisches Patentamt

European Patent Office

Office européen des brevets

(11) Publication number: **0 266 142**
A1

(12) **EUROPEAN PATENT APPLICATION**

(21) Application number: 87309414.8

(51) Int. Cl.4: **H 01 L 31/02**
H 01 L 31/18

(22) Date of filing: 21.10.87

(30) Priority: 27.10.86 GB 8625664

(43) Date of publication of application:
04.05.88 Bulletin 88/18

(84) Designated Contracting States:
BE DE ES FR GB GR IT NL

(71) Applicant: **PRUTEC LIMITED**
**142 Holborn Bars**
**London EC1N 2NH (GB)**

(72) Inventor: **Cumberbatch, Toby John**
**33 Cavendish Road**
**Cambridge CB1 3AE (GB)**

(74) Representative: **Messulam, Alec Moses**
**A. Messulam & Co. 24 Broadway**
**Leigh on Sea Essex SS9 1BN (GB)**

(54) Cadmium Sulphide Solar cells.

(57) A method is disclosed for forming a polycrystalline thin film on a transparent substrate based on the spraying of a suitable precursor solution onto the substrate and heating the substrate to evaporate the precursor solvent on the substrate.

In the invention, the droplets of precursor solution are electrostatically charged and are electrostatically attracted to the surface of the substrate. Furthermore the droplets impinging on the surface of the substrate are heated by radiant energy incident upon the surface of the substrate from the opposite side from the spray.

1/1

EP 0 266 142 A1

## Description

## CADMIUM SULPHIDE SOLAR CELLS

The present invention relates to the growth of polycrystalline thin films and has particular application to the manufacture of the cadmium sulphide layer in cadmium sulphide solar cells.

Various techniques have been adopted in the past for the formation of a polycrystalline cadmium sulphide layer on a substrate consisting of glass coated with a transparent electrode, of for example tin oxide. These techniques have included vapour deposition which is generally unacceptable from a commercial viewpoint as it requires high capital investments and is difficult to incorporate into a continuous manufacturing process. This technique also requires skilled operators and does not lend itself to implementation in third world countries.

A more promising technique which has been proposed in the past has been to spray a precursor solution onto the heated substrate, the solution containing materials such as cadmium chloride and thiourea which react with one another, the reaction product undergoing pyrolytic decomposition to yield a layer of cadmium sulphide.

The use of this technique in the past has however yielded thin films of inferior quality as compared with vapour deposited films for reasons which have not been fully understood. Furthermore, such implementations as have succeeded in achieving acceptable electrical efficiency have involved prolonged spraying times, which are again inconsistent with large volume production.

The present invention seeks to provide a method of depositing a polycrystalline thin film on a substrate, which mitigates at least some of the foregoing disadvantages.

According to one aspect of the present invention, there is provided a method of forming a polycrystalline thin film on a transparent substrate, which comprises spraying a suitable precursor solution onto the substrate and heating the substrate to evaporate the precursor solvent on the substrate, characterised in that the droplets of precursor solution are electrostatically charged and are electrostatically attracted to the surface of the substrate, and in that droplets impinging on the surface of the substrate are heated by radiant energy incident upon the surface of the substrate from the opposite side from the spray.

It will be appreciated that the term transparent as used above refers to properties of the substrate at the wavelength of the radiant energy and it need not necessarily be transparent to visible light.

The evaporation of precursor solvent involves the input of heat to the deposition surface and hitherto this has been effected by the use of a so-called fluidised bed consisting, for example of a bath of molten tin on which the substrate floats. The present invention recognises that in such a method of heating the heat flux per unit area is limited by the thermal conductivity of the substrate. The temperature of the molten tin is more or less constant and the thermal flux depends only on the material of the substrate and its thickness. Under these conditions, it has not been possible to achieve sufficient heat flow through the substrate to result in a thin film of high quality and at the same time reach an acceptable rate of growth of the film. In other words, as the heat flow could not be increased, the precursor flow rate per unit area had to be kept down if the crystal structure was not to be adversely affected.

The solution to the problem of inadequate heat flux, in accordance with the invention, is to make use of radiant energy for heating the precursor droplets as they fall on the substrate. In the case of a cadmium sulphide solar cell, the "transparent" electrode on the substrate is, surprisingly, sufficiently absorbent to enable the temperature of the substrate surface to be increased significantly (50°C) as compared with the temperature of the surface when heated by a tin bath. It is of course not only the initial temperature that is of importance but the temperature during spraying when it is being cooled by the precursor droplets.

However, even the increased temperature of the surface is not sufficient to achieve the required properties under high rates of growth. Indeed, growth can take place at a very slow rate despite high rates of heat flux to the surface if the spray droplets are not electrostatically charged. Furthermore, in the absence of such an electrostatic charge, the surface of the deposited layer is rough and exhibits protrusions which are scattered over the surface and are incorporated in the crystal lattice of the film. The reasons for the occurrence of these protrusions are not fully understood but it is believed that the action of the electrostatic charge is to aid impact as above and to prevent coalescence of droplets in the mist and on the surface of the substrate ( if they should not evaporate on the instant of impact).

The electrostatic head used to spray the precursor solution may be of the same type as used in electrostatic paint spraying but it will be appreciated that in that application the main aim of the electrostatic charge is to achieve full coverage of the painted article whereas in the present invention, the aim is to prevent coalescence of droplets. In paint spraying, the main potential difference is between the spray head and the article.

Manufacturers recommendations for the use of the spray heads with conductive liquids is to employ long electrodes projecting from the vicinity of the spray orifice to avoid the static charge being leaked through the conductive liquid of the spray. In carrying out the present invention, however, it has been found that long electrodes do not give satisfactory results but good results are achieved by the use of electrodes.

The atomisation of the precursor is preferably carried out in an air-less manner by passing the liquid under high pressure through a very fine orifice. A gas orifice surrounding the orifice is advantageously provided to assist the transportation of the droplets in the direction of the substrate, to act as a barrier on the surface of the substrate and to modify the distribution of the spray. Despite the presence of a gas stream, this spray should not be confused with one where the precursor is atomised by the gas stream by carburetion.

Preferably the substrate is supported on a ceramic hob heated from below by heating elements which are conveniently elongate and are fitted with reflectors to direct the energy output onto the hob.

In the making of large area thin films, it is important to be able to maintain an even rate of heating and this can be achieved by moving the hob relative to the heating elements in a generally circular path.

If desired, the substrate may additionally be heated by radiant energy directed onto the deposition surface from above, that is to say the same direction as the spray.

The hob may be formed of the glass like ceramic material used in certain domestic hobs.

Advantageously, means are provided for measuring the surface temperature of the substrate and controlling the heating of the substrate to maintain the desired temperature.

The invention has been described in relation to the deposition of a cadmium sulphide film but it will be clear that it can be used for deposition of other thin films of other materials such as zinc sulphide, copper indium diselenide or other binary, ternary or quaternary compounds with a wurtzite, chalcopyrite or perovskite crystal structure. The last include certain ceramic materials which exhibit superconductivity at relatively elevated temperatures and which are at present being extensively investigated.

In the case of a cadmium sulphide solar cell, after the cadmium sulphide layer has been formed on the substrate, it is necessary to form a photoelectric junction with the cadmium sulphide by forming over it a layer of copper sulphide. Usually the copper sulphide layer is grown topotaxially, that is to say the cadmium is replaced by copper in the upper region of the thin film.

Hitherto, spraying and immersion techniques have been suggested to form the copper sulphide layer. An acidic aqueous solution containing cuprous ions is made to contact the surface of the cadmium sulphide layer for about 5 seconds and at about 90°C.

Analysis of the structure of the heterojunction formed by this process was performed in a scanning electron microscope. The cuprous sulphide layer was removed with an aqueous solution of potassium cyanide to reveal the unreacted cadmium sulphide film. In a similar manner, the microstructure of the cuprous sulphide layer was exposed by dissolving the cadmium sulphide in hydrochloric acid. It was found, confirming published evidence, that the cuprous sulphide film had penetrated into the interstices of the crystal structure by more rapid growth down the grain boundaries. Such growth risks short circuiting of the heterojunction and thicker cadmium sulphide films than necessary must be employed to reduce such risk.

In accordance with a second aspect of the present invention, there is provided a method of forming a copper sulphide / cadmium sulphide heterojunction which comprises immersing a cadmium sulphide layer in an organic solution containing a cuprous salt while ensuring that sufficient energy reaches the surface to stimulate the growth of a topotaxial layer of copper sulphide on the cadmium sulphide.

The energy may be applied to the surface either in the form of heat or light. It is, in practice, simpler to heat the solution but at first it was doubted that this would be sufficient to reduce grain boundary penetration. Nevertheless, it has surprisingly been found that with certain solvents, notably propionitrile ($C_2H_5CN$), heat alone is all that is required. With other solvents, for example acetonitrile, the higher energy density achievable by a laser, such as a carbon dioxide laser, is required to permit ion exchange at an acceptable rate.

It should be stressed that the solvents mentioned above are not intended to constitute an exhaustive list. Other solutions of copper complexes are described in the article "Copper(I) Complexes" by F.H.Jardine in Advances in Inorganic Chemistry and Radiochemistry 17 (1975) 116.

Similar electron microscope analysis of samples of heterojunctions prepared by dipping cadmium sulphide in an organic solution of cuprous iodide has shown negligible grain boundary penetration and an almost optimised interface when the organic solvent was benzonitrile ($C_6H_5CN$), which can also be termed phenyl cyanide. The copper sulphide was also found by X-ray diffraction to be of the desired chalcocite phase.

The invention will now be described further by way of example, with reference to the accompanying drawings, in which the single figure shows apparatus for the deposition of a cadmium sulphide layer.

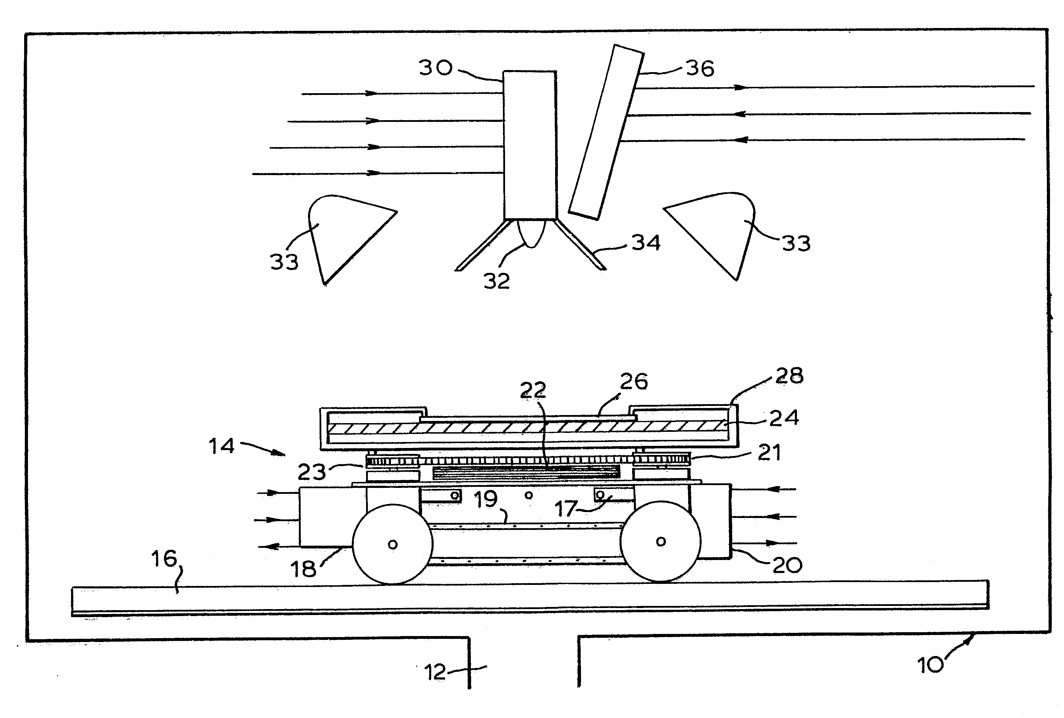

The apparatus in Figure 1 comprises a stainless steel enclosure 10 which is vented to atmosphere through an exhaust port 12. Within the enclosure 10 there is provided a trolley 14 movable along a railway track 16. The trolley 14 is fitted with heating elements in the form of tungsten halogen lamps 22 disposed beneath a support structure 28 carrying a ceramic plate 24 on which rests the substrate 26 to be coated with cadmium sulphide. The substrate 26 consists of a glass plate having a transparent conductive layer of tin oxide.

The trolley 14 carries two motors 18 and 20, the first to effect traverse of the substrate 26 and the second to rotate the substrate during the deposition process. This movement is to assure even exposure both to the heat from the heating elements 22 and to the spray from a spray head 30 fitted with an elliptical nozzle 32.

The mechanism for moving the substrate 26 during the deposition process includes a chain drive 19 for the traverse and a second chain drive 21 and bearings 23 for rotation of the ceramic plate. However, it is not deemed necessary to describe the displacement mechanism in detail within the present context as it is not fundamental to the invention.

Various lines are shown leading to the motors and to the trolley 14. These include lines associated with position and temperature sensing and control lines for controlling the traverse and the rotation of the substrate.

The parts of the apparatus disposed above the trolley 14 include, in addition to the previously mentioned spray head 30, two further tungsten halogen lamps 33, two EHT electrodes 34 arranged one on each side of the nozzle 32 of the spray head 30 and an optical pyrometer 36 arranged adjacent the spray head 30. In use, a corona discharge should take place in the vicinity of the spray nozzle in order to ionise the droplets. Such a corona discharge is assisted by placing pointed electrodes which are at a floating electrostatic potential adjacent the spray orifice.

The lines leading to the spray head 30 represent the pneumatic control lines for emission control, the EHT (90 KV max) and also the supply lines for conveying the precursor solution to the spray head and the nitrogen to assist in the formation of the spray, as earlier mentioned. Lastly, the lines leading from the pyrometer 36 represent an output line indicating the surface temperature and two supply lines conveying cooling water and gas for forming a curtain to protect the pyrometer.

Spray pyrolysis has been the subject of much investigation since it was first reported in 1966 by Chamberlin and Skarman (J. Electrochem. Soc. 113,86). Its use as a manufacturing technique for large area solar cells was first suggested by J.F.Jordan in 1973 (Workshop Proc., Photo. Conv. Solar Energy Terr. Appl.,Cherry Hill, p.182) and it is an economic method for the deposition of semiconductor layers.

A majority of the work reported in the literature has employed conventional air atomisation of an aqueous precursor whilst the temperature of the substrate is maintained by a hob or liquid tin bath. This leads to very slow deposition rates because the growth surface is cooled substantially by the gas jet and means that low droplet fluxes must be employed to avoid excessive heat loss.

Vedel and co-workers (3) (Proc. 4th EC Photovoltaic Solar Energy Conf., Stresa [Reidel] p.818) were the first to investigate airless atomisation for the spray pyrolysis of cadmium sulphide and showed that it led to a dramatic increase in the growth rate with a corresponding decrease in energy consumption. However, their initial results suggested that the quality of the films could be improved.

It has been experimentally found that the key parameter in this process is the temperature of the growth surface at the point of droplet impact and is determined by the droplet size, flux and momentum, and the available heat flux. In the preferred embodiment of the present invention as described above, it believed possible to achieve a reduced droplet size, increased concentration of the precursor and heat flux, and these have made it possible to increase the growth rate significantly while improving the quality of the deposited layer as compared with the prior art.

In the apparatus as illustrated, a Wagner Air-Coat A100 AC spray gun 30 is employed to produce an aerosol containing fine droplets. The fan shaped nozzle 32 is used to generate an elliptical droplet field across the traverse axis of the substrate 26 which results in a more uniform temperature drop over the exposed region. The tin oxide coated glass substrate 26 rests on a partially transparent sheet of Corning 9617 ceramic plate 24 which is heated from below by a bank of tungsten halogen lamps 22. This permits direct energy input to the growing film as does the further set of lamps 33 above the substrate 26. The surface temperature is measured by the optical pyrometer 36 (Omegascope 11) which controls the power input to the lower lamps 22. The position of the spray gun 30 is fixed whilst the substrate 26 executes a trochoid in the horizontal plane. This arrangement produces uniform films over an area of 100cm$^2$ and is limited only by the dimensions of the hob.

The optimum deposition conditions are dictated by the rate of surface cooling due to solvent evaporation and hence the maximum available heat flux. The most preferred method currently for depositing a cadmium sulphide layer on a substrate is effected under the following conditions:

1. Surface temperature 450°C

2. Traverse rate of hob relative to the nozzle 25mm.s$^{-1}$; Rotation rate: 5 rads/s

3. Fluid pressure: 20 Bar (0.3 ml.s$^{-1}$); Nitrogen pressure; 0.8 Bar

4. Electrode Voltage: 60KV

5. Solution Concentration: 0.1M (0.2M is possible)

6. Nozzle orifice size approx. 75 microns.

In the preferred technique for the fabrication of topotaxial cuprous sulphide, the cadmium sulphide layer is immersed in a solution of copper iodide in propionitrile and the exchange reaction stimulated by heating the solution to a temperature of 95°C. The concentration of the copper iodide in the propionitrile is in the region of 10 grams/litre and the reaction time is in the region of 30 secs. This results in a layer having a thickness of approximately 0.3 microns.

The organic solvent forces copper into a monovalent oxidation state in an organic complex and this offers the additional advantage of stabilising the cuprous ion.

It has been found that the method of deposition outlined above results in excellent crystal alignment and this has been demonstrated by X-ray diffraction spectra. This method of examination has shown that for surface temperatures less than approximately 450°C, the degree of alignment falls rapidly although the material remains hexagonal.

The chemical composition of the film has also been determined using laser mass spectrometry (LIMA2A) which has a quoted resolution of a few parts per million for most common elements. Results obtained show that the pyrolytic decomposition reaction proceeds to completion.

The electronic properties of the material have been assessed from standard electrical measurements and cathodoluminescence. The CL spectrum obtained reveals strong band edge luminescence, acknowledged to be a necessary prerequisite for efficient solar cells.

## Claims

1. A method of forming a polycrystalline thin film on a transparent substrate, which comprises spraying a suitable precursor solution onto the substrate and heating the substrate to evaporate the precursor solvent on the substrate, characterised in that the droplets of precursor solution are electrostatically charged and are electrostatically attracted to the surface of the substrate, and in that droplets impinging on the surface of the substrate are heated by radiant energy incident upon the surface of the substrate from the opposite side from the spray.

2. A method as claimed in claim 1, wherein the electrostatic head used to spray the precursor solution is fitted with short electrodes projecting from the vicinity of the spray orifice to promote ionisation of the droplets.

3. A method as claimed in claim 1 or 2, wherein the atomisation of the precursor is carried out in an airless manner by passing the liquid under high pressure through a fine orifice.

4. A method as claimed in claim 3, wherein a gas orifice surrounding the orifice is provided to assist the transportation of the droplets in the direction of the substrate, to act as a barrier on the surface of the substrate and to modify the distribution of the spray.

5. A method as claimed in any preceding claim, wherein the substrate is supported on a ceramic hob heated from below by radiant heating elements.

6. A method as claimed in claim 5, wherein the heating elements are elongate quartz-halogen lamps fitted with reflectors to direct the energy output onto the hob.

7. A method as claimed in claim 5 or 6, wherein the hob is moved relative to the heating elements in a generally circular path.

8. A method as claimed in claim 5, 6 or 7, wherein the substrate is additionally heated by radiant energy directed onto the deposition surface from the same direction as the spray.

9. A method as claimed in any preceding claim, wherein the surface temperature of the substrate is measured and the energy input for heating the substrate is controlled in such a manner as to maintain the measured temperature at a desired level.

10. A method of forming a cadmium sulphide solar cells, wherein the cadmium sulphide layer is deposited onto a substrate consisting of glass having an electrically conductive transparent coating by the method of any preceding claim, and wherein after deposition of the cadmium sulphide layer a copper sulphide / cadmium sulphide heterojunction is formed by immersing the cadmium sulphide layer in an organic solution containing a copper salt while ensuring that sufficient energy reaches the surface to stimulate the growth of a topotaxial layer of copper sulphide on the cadmium sulphide.

11. A method as claimed in claim 10, wherein energy is applied to the surface in the form of heat, the organic solvent used for the solution containing copper ions being propionitrile or benzonitrile.

0266142

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-2 020 856 (PHOTON POWER, INC.) <br> * Page 3, line 48 - page 5, line 4; page 6, lines 7-15; page 7, lines 4-31; page 9, line 22 - page 10, line 24; claims 1,18,19,22,23; figures 1-5 * <br> --- | 1,5,6,9,10 | H 01 L 31/02 <br> H 01 L 31/18 |
| X | GB-A-1 506 160 (PHOTON POWER, INC.) <br> * Page 1, line 76 - page 4, line 5; page 5, line 91 - page 6, line 59 * <br> --- | 1,8-10 | |
| A | US-A-4 104 420 (J.F. JORDAN) <br> * Claims; figures * <br> --- | 1,8-10 | |
| A | US-A-4 304 607 (J.F. JORDAN) <br> --- | | |
| P,A | SOLAR ENERGY MATERIALS, vol. 15, no. 6, September 1987, pages 453-461, Elsevier Science Publishers B.V., Amsterdam, NL; H. AMLOUK et al.: "Structural, optical and electrical properties of $SnO_2$:F and CdS airless sprayed layers" <br> * Pages 453-454 * <br> ----- | 1,3 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 08-01-1988 | VISENTIN A. |

EPO FORM 1503 03.82 (P0401)